(19) **Europäisches Patentamt**

**European Patent Office**

**Office européen des brevets**

(11) **EP 1 196 991 B1**

(12) **EUROPÄISCHE PATENTSCHRIFT**

(45) Veröffentlichungstag und Bekanntmachung des Hinweises auf die Patenterteilung:
**15.06.2005  Patentblatt 2005/24**

(51) Int Cl.$^7$: **H03H 9/64**

(21) Anmeldenummer: **00956061.6**

(86) Internationale Anmeldenummer:
**PCT/DE2000/002202**

(22) Anmeldetag: **06.07.2000**

(87) Internationale Veröffentlichungsnummer:
**WO 2001/005031 (18.01.2001 Gazette 2001/03)**

(54) **SAW-FILTER DES REAKTANZFILTERTYPS MIT VERBESSERTER SPERRBEREICHSUNTERDRÜCKUNG UND VERFAHREN ZUR OPTIMIERUNG DER SPERRBEREICHSUNTERDRÜCKUNG**

SURFACE ACOUSTIC WAVE (SAW) FILTER OF THE REACTANCE FILTER TYPE EXHIBITING IMPROVED STOP BAND SUPPRESSION AND METHOD FOR OPTIMIZING THE STOP BAND SUPPRESSION

FILTRE A ONDES DE SURFACE DE TYPE FILTRE A REACTANCE A SUPPRESSION AMELIOREE DE LA BANDE DE FREQUENCES NON TRANSMISES ET PROCEDE D'OPTIMISATION DE LA SUPPRESSION DE LA BANDE DE FREQUENCES NON TRANSMISES

(84) Benannte Vertragsstaaten:
**CH DE FR GB LI**

(30) Priorität: **13.07.1999  DE 19932649**

(43) Veröffentlichungstag der Anmeldung:
**17.04.2002  Patentblatt 2002/16**

(73) Patentinhaber: **EPCOS AG**
**81669 München (DE)**

(72) Erfinder: **SELMEIER, Peter**
**D-83558 Maitenbeth (DE)**

(74) Vertreter: **Epping Hermann & Fischer**
**Ridlerstrasse 55**
**80339 München (DE)**

(56) Entgegenhaltungen:
**EP-A- 0 862 266      EP-A- 0 878 902**
**EP-A- 0 878 905      EP-A- 0 897 218**
**DE-A- 19 730 710      US-A- 4 864 470**

- **MINEYOSHI S ET AL: "ANALYSIS AND OPTIMAL SAW LADDER FILTER DESIGN INCLUDING BONDING WIRE AND PACKAGE IMPEDANCE" IEEE ULTRASONICS SYMPOSIUM PROCEEDINGS,US,NEW YORK, NY: IEEE, 5. Oktober 1997 (1997-10-05), Seiten 175-178, XP000848470 ISBN: 0-7803-4154-6**

**Beschreibung**

Die vorliegende Erfindung betrifft ein Oberflächenwellenfilter (OFW oder englisch SAW) und speziell ein SAW-Filter nach dem Reaktanzfiltertyp mit verbesserter Sperrbereichsunterdrückung sowie ein Verfahren zur Optimierung der Sperrbereichsunterdrückung.

Reaktanzfilter sind aus der klassischen Filtertechnik bekannt. Werden statt diskreter Elemente (Induktivitäten und Kapazitäten) für die einzelnen Resonatoren SAW-Resonatoren verwendet, so spricht man von SAW-Filter nach dem Reaktanzfiltertyp.

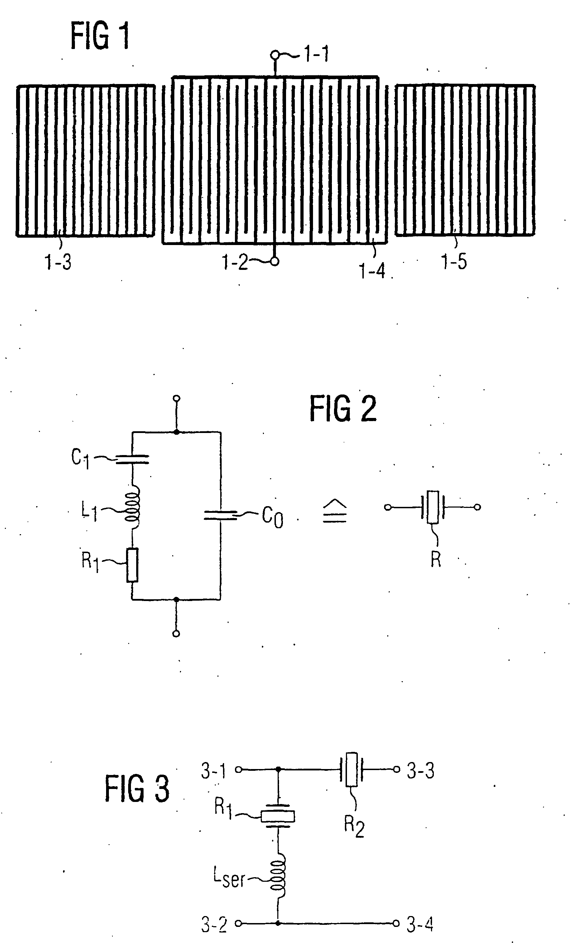

Bei SAW-Filter nach dem Raktanzfiltertyp werden als Impedanzelemente SAW-Resonatoren verwendet. Figur 1 zeigt den schematischen Aufbau eines bekannten Resonators. Er weist metallische Strukturen auf der Oberfläche eines piezoelektrischen Substrats auf und besitzt ein Anschlußpaar 1-1 und 1-2, an dem ein Interdigitalwandler 1-4 zur Transformation von elektrischer in akustische Energie angeschlossen ist. Auf beiden Seiten des Interdigitalwandlers 1-4 ist längs der akustischen Achse jeweils ein Reflektor 1-3 und 1-5 angeordnet um zu verhindern, daß die akustische Energie entweicht.

Fig. 2 zeigt links das Ersatzschaltbild für einen SAW-Resonator R und rechts das für den Resonator verwendete Symbol. Im ersten Zweig der Parallelschaltung befindet sich eine Serienresonanzschaltung aus dynamischer Induktivität $L_1$, dynamischer Kapazität $C_1$ und dynamischem Widerstand $R_1$ (bei Berücksichtigung von Verlusten) und im zweiten Zweig die statische Kapazität $C_0$ des Interdigitalwandlers. Die Serienresonanzschaltung gibt das Verhalten des Resonators im Resonanz fall wieder, also im Bereich der Resonanzfrequenz $f_r$. Die statische Kapazität gibt das Verhalten in den Frequenzbereichen $f \ll f_r$ und $f \gg f_r$ wieder. Die dynamische Kapazität $C_1$ ist proportional zur statischen Kapazität $C_0$ des Interdigitalwandlers:

$$C_1 \sim C_0. \qquad (1.1)$$

Ein Resonator besitzt eine Resonanzfrequenz $f_r$ und eine Antiresonanzfrequenz $f_a$. Für die Resonanzfrequenz $f_r$ gilt:

$$f_r = \frac{1}{2\pi\sqrt{L_1 * C_1}} \qquad (1.2)$$

Für die Antiresonanzfrequenz $f_a$ eines Resonators gilt:

$$f_a = f_r * \sqrt{1 + \frac{C_1}{C_0}} \qquad (1.3)$$

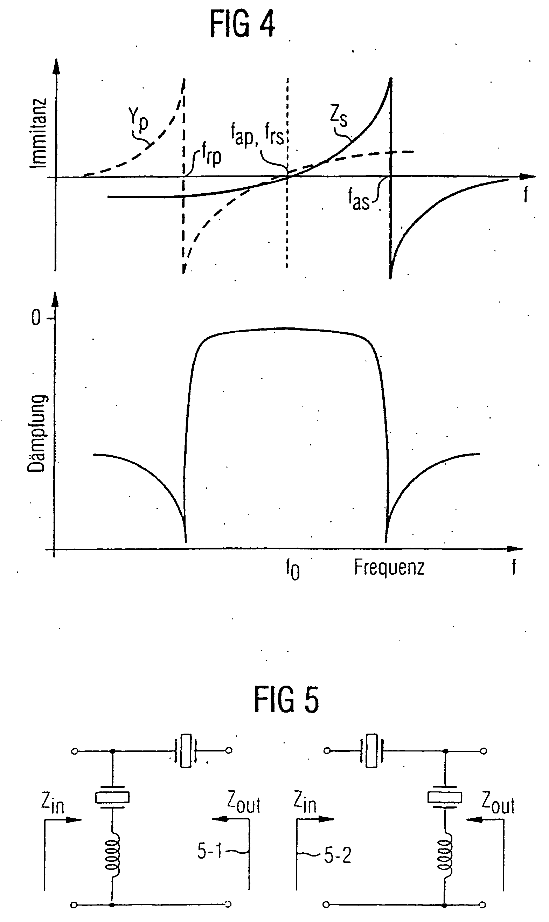

Basiseinheit eines SAW Reaktanzfilters ist ein sogenanntes Grundglied, wie es in Fig. 3 dargestellt ist. Es besteht aus einem ersten Resonator $R_1$ mit Resonanzfrequenz $f_{rp}$ und zugehöriger Antiresonanzfrequenz $f_{ap}$ im parallelen Zweig und einem zweiten Resonator $R_2$ mit Resonanzfrequenz $f_{rs}$ und zugehöriger Antiresonanzfrequenz $f_{as}$ im seriellen Zweig. Der Frequenzverlauf der Admittanz Yp des Resonators $R_1$ im parallelen Zweig und der Frequenzverlauf der Impedanz $Z_s$ des Resonators $R_2$ im seriellen Zweig sind in Fig. 4 dargestellt. Zur Erzeugung eines Bandpaßfilters mit der Mittenfrequenz $f_0$ haben die Resonanzfrequenzen der beiden Resonatoren folgenden Zusammenhang:

$$f_{ap} \approx f_{rs} \approx f_0 \qquad (1.4)$$

Jedes Grundglied ist prinzipiell als Zweitor mit den Anschlüssen 3-1 bzw. 3-2 von Tor 1 und den Anschlüssen 3-3 bzw. 3-4 von Tor 2 zu betrachten (siehe Fig. 3). Gleichzeitig ist der Anschluß 3-1 der Eingang und der Anschluß 3-3 der Ausgang des Serienresonators. Der Eingang des Parallelresonators ist mit dem Anschluß 3-1 verbunden. Die Anschlüsse 3-2 und 3-4 stellen bei einem unsymmetrischen Betrieb die Bezugsmasse dar. Der Ausgang 3-5 des Parallelresonators, der der Bezugsmasse zugewandt ist, wird im folgenden als Ausgangs- bzw. Masseseite des Parallelresonators genannt. Die Induktivität $L_{ser}$, die zwischen der Ausgangsseite des Parallelresonators und der Bezugsmasse liegt, spiegelt den Anschluß an die Gehäusemasse im realen Aufbau wieder.

Das Selektionsniveau des SAW-Filters nach dem Reaktanzfiltertyp wird zum einen durch das Verhältnis $C_{0p}/$

$C_{0s}$ aus statischer Kapazität $C_{0p}$ im Parallelzweig und statischer Kapazität $C_{0s}$ im Serienzweig bestimmt, zum anderen durch die Anzahl der hintereinander geschalteten (kaskadierten) Grundglieder.

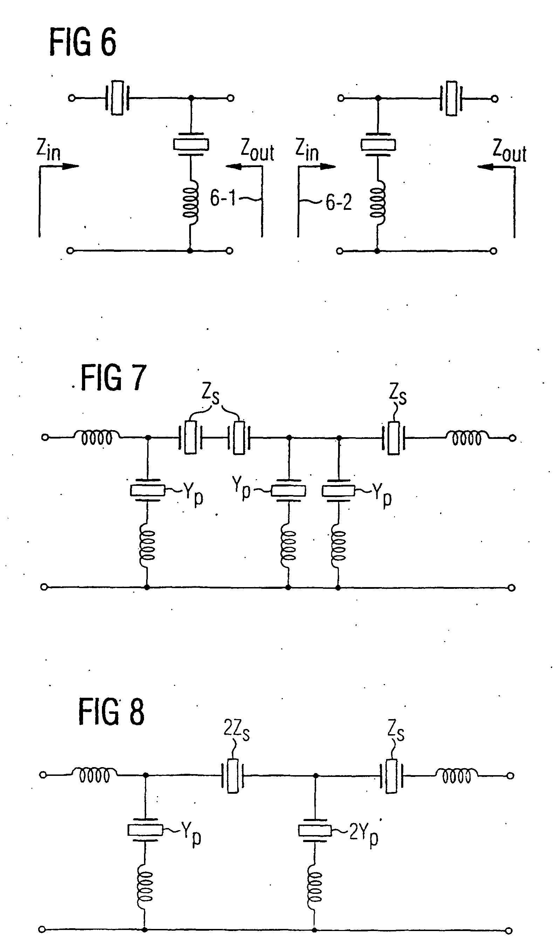

Die Grundglieder werden im Falle einer Kaskadierung üblicherweise angepaßt verschaltet, das heißt, jeweils gespiegelt. Fig. 5 und Fig. 6 zeigen zwei Beispiele eines.Reaktanzfilters, bei dem jeweils zwei Grundglieder kaskadiert sind. Die Ausgangsimpedanz 5-1 ($Z_{out}$) bzw. 6-1 ($Z_{in}$) des ersten Grundgliedes ist gleich der Eingangsimpedanz 5-2 bzw. 6-2 des zweiten Grundgliedes, wodurch die Verluste durch Fehlanpassung minimal sind. Bezüglich Anzahl und Anordnung der Grundglieder sind für Reaktanzfilter vielerlei Strukturen möglich oder bekannt.

Unmittelbar hintereinanderliegende Resonatoren gleichen Typs (Serienresonator oder Parallelresonator) können auch zu jeweils einem zusammengefaßt werden, wobei die kapazitive Gesamtwirkung gleich bleibt. Die Verschaltung eines Filters gemäß Fig. 7 entspricht in der Wirkung der eines Filters nach Fig. 8.

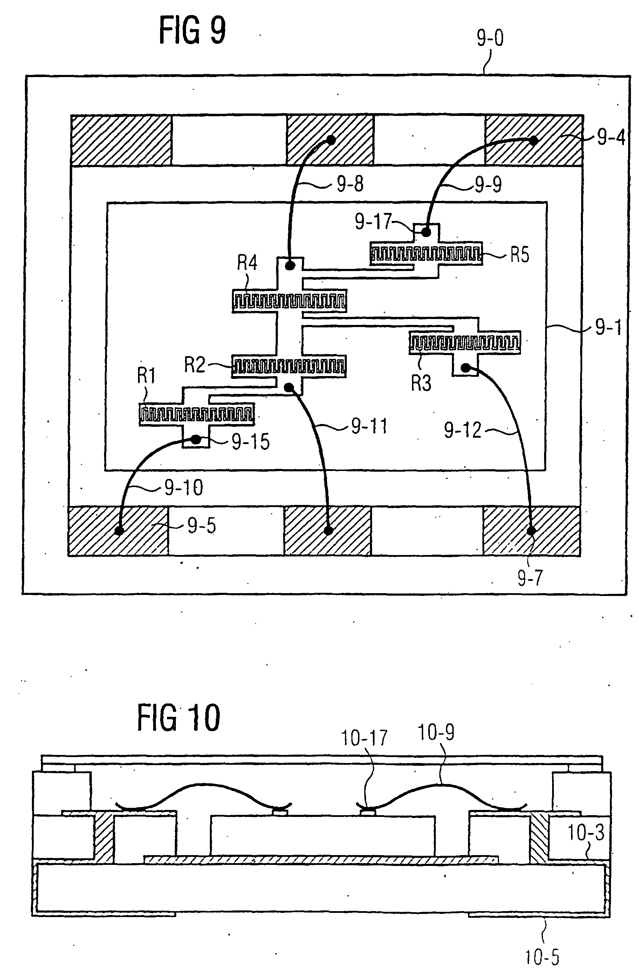

Die Fig. 9 und 10 zeigen den typischen tatsächlichen Aufbau eines SAW-Filters auf einem piezoelektrischen Substrat 9-1 in einem Keramikgehäuse 9-0 und die typische Verbindungstechnik mit Bonddrähten 9-8 bis 9-12 bzw. 10-9.

Die Parallelresonatoren R1, R3 und R5 werden an der Ausgangsseite 9-15 bis 9-17 über Bonddrähte 9-9, 9-10 und 9-12 mit den Gehäusemassepads 9-4, 9-5 und 9-7 verbunden.

Durch die typische Aufbautechnik (siehe Fig. 9 und Fig. 10) erhält man bei dem Anschluß der Parallelzweige an Masse Serieninduktivitäten zwischen z.B. der Ausgangsseite 9-17 des Parallelresonators R5 auf dem Substrat (Chip) 9-1 und der am äußeren Gehäusepin 9-4 anliegenden Masse 10-5. Dazu zählen im wesentlichen der induktive Anteil der Streifenleitung auf dem Chip, die Induktivität der Bondverbindung 9-9 und die der Gehäusedurchführung 10-3.

Diese Serieninduktivitäten beeinflussen das Verhalten des Filters sowohl im Durchlaßbereich als auch im Sperrbereich. Für den Durchlaßbereich gilt $f \sim f_0$. Die Resonanzfrequenz und damit die Bandbreite eines Resonators kann bekanntermaßen durch eine zum Resonator gehörige externe Beschaltung verändert werden. Eine Induktivität seriell zum Resonator erhöht die effektive dynamische Induktivität, wodurch die Resonanzfrequenz $f_r$ sinkt. Da die Antiresonanzfrequenz $f_a$ nur in sehr geringem Maße verschoben wird, wird die Bandbreite $\Delta f = f_a - f_r$ eines Resonators mit serieller Induktivität vergrößert. Im Falle eines Parallelresonators wird auch die Bandbreite des SAW-Filters vergrößert.

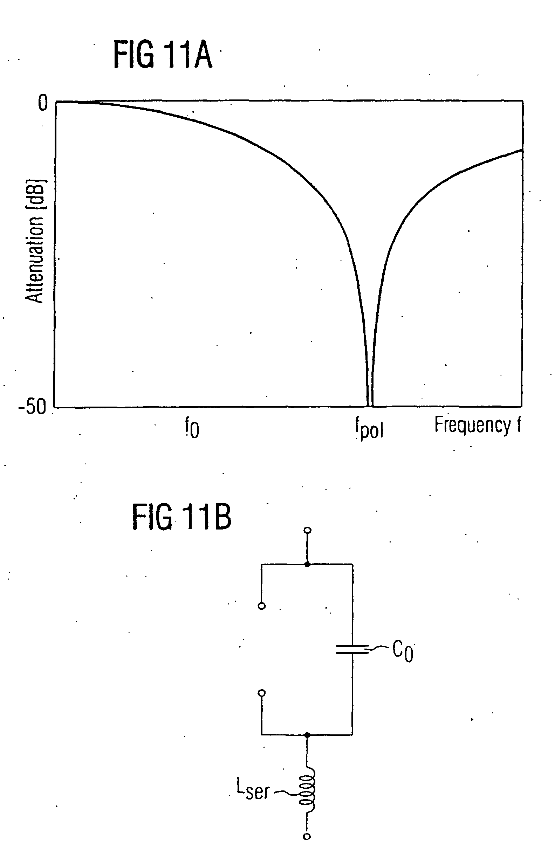

Für den Sperrbereich gilt $f \ll f_0$ und $f \gg f_0$. Hier ist das Ersatzschaltbild eines Resonators reduziert auf seine statische Kapazität $C_0$, da der Serienschwingkreis außerhalb $f_0$ sehr hochohmig ist und einem Leerlauf entspricht. Eine Induktivität $L_{ser}$ seriell zum Resonator ergibt einen in Fig. 11 dargestellten Serienschwingkreis mit einer Resonanzfrequenz

$$f_{pol} = \frac{1}{2\pi\sqrt{L_{ser} * C_0}} \qquad (1.5).$$

Im Falle einer Induktivität seriell zu einem Parallelresonator bedeutet dies, daß bei der Frequenz $f_{pol}$ die Energie des Filters direkt nach Masse abfließen kann, es bildet sich in der Filterkurve eine sogenannte Polstelle aus, also eine erhöhte Unterdrückung im Sperrbereich. Die Anzahl der Polstellen im Sperrbereich entspricht der Anzahl der Parallelzweige mit Serieninduktivität. Frequenzmäßig unterscheidbare Polstellen $f_{pol1}$ und $f_{pol2}$ ergeben sich nur bei unterschiedlichen Produkten $\Pi_1 = L_{ser1} * C_{01}$ und $\Pi_2 = L_{ser2} * C_{02}$. Sind die Produkte identisch, so liegen die Polstellen bei der gleichen Frequenz, man erhält eine doppelte Polstelle $f_{pol} = f_{pol1} = f_{pol2}$ mit einer höheren Unterdrückung als bei einer einfachen Polstelle.

Fig.11a zeigt das Dämpfungsverhalten eines Resonators im Parallelzweig, an den eine Induktivität $L_{ser}$ seriell an die Ausgangsseite des Parallelresonators angeschlossen ist. Wie in Fig. 11b wurde der Serienschwingkreis des Resonators, dessen Resonanzfrequenz $f_{rp}$ gleich $f_0$ ist, zur Verdeutlichung der Polstelle entfernt. Für die Frequenz der Polstelle $f_{pol}$ gilt typisch $f_{pol} > f_0$, wobei $f_0$ gleich der Resonanzfrequenz des Filters. Für die Polstelle erhält man eine hohe Dämpfung.

SAW-Filter nach dem Reaktanzfiltertyp werden vornehmlich als HF-Filter im Mobilfunkbereich eingesetzt, da sie sehr geringe Verluste im Durchlaßbereich aufweisen. Als HF-Filter im Mobilfunkbereich muß das SAW-Filter nach dem Reaktanzfiltertyp darüberhinaus zum einen das Duplexband (bei einem Sendefilter also das Empfangsband und bei einem Empfangsfilter umgekehrt das Sendeband) und zum anderen das Signal bei der Lokaloszillatorfrequenz (LO) und/oder bei der Spiegelfrequenz (Imagefrequenz) unterdrücken, um ungewollte Mischprodukte im Telefon zu verhindern.

Der Lokaloszillator liegt oberhalb oder unterhalb der Mittenfrequenz $f_0$ des Filters. Der Abstand zur Mittenfrequenz $f_0$ entspricht der zur Signalaufbereitung verwendeten Zwischenfrequenz (ZF). Die Spiegelfrequenz hat den Abstand $2 * ZF$ zur Mittenfrequenz $f_0$. Da momentan ZF-Frequenzen im Bereich 100-400 MHz verwendet werden, muß das SAW-Filter je nach Anwendung im Bereich $f_0$ plus/minus 100-800 MHz gute Dämpfungseigenschaften von typisch mehr als 30dB aufweisen. In den häufigsten Fällen liegt der Lokaloszillator oberhalb der Mittenfrequenz $f_0$.

Um eine ausreichende Dämpfung im Bereich der LO- und/oder Imagefrequenz zu erreichen, gibt es verschiedene Möglichkeiten. Möglichkeit A besteht darin, das allgemeine Selektionsniveau (als Maß hierfür gilt die minimale Dämpfung unterhalb des Durchlaßbereiches bei ca. $f_0$/2) entsprechend groß zu machen. Der große Nachteil ist jedoch, daß mit zunehmendem Selektionsniveau auch die Verluste im Durchlaßbereich steigen. Das ist in den meisten Fällen inakzeptabel für die Signalverarbeitung im Telefon. Die zweite Möglichkeit B ergibt sich aus der oben beschriebenen Tatsache, daß eine bei der herkömmlichen Aufbautechnik vorhandene Induktivität seriell zu einem Parallelresonator eine Polstelle erzeugt, die gerade bei der LO- oder Imagefrequenz liegt. Bei dem großen Spektrum an verwendeten ZF-Frequenzen muß in diesem Falle eine Möglichkeit gegeben sein, um die erzeugte Polstelle über einen Bereich von ca. 700 MHz zu variieren.

Da die statische Kapazität $C_{0p}$ im Parallelzweig maßgeblich die Filterperformance (Passband, Anpassung und Selektionsniveau) bestimmt, kann sie bei gegebenen Filteranforderungen nur in sehr geringem Maße so variiert werden, daß sich gleichzeitig auch noch die Lage von Polstellen im Sperrbereich verändert. Ebenso ist der Freiheitsgrad für die Größe der Induktivität seriell zwischen Ausgangsseite des Parallelresonators und Masse beschränkt. Durch den Zwang zur Miniaturisierung und auch aus Kostengründen werden die verwendeten Chips immer kleiner, was zur Folge hat, daß der induktive Anteil der Streifenleitung auf dem Chip nur begrenzt verändert werden kann. Die Länge und die damit korrelierende Induktivität der Bondverbindung kann innerhalb eines Gehäuses im Zuge der weiter fortschreitenden Miniaturisierung ebenfalls kaum mehr variiert werden. Außerdem ist die Induktivität, die sich aus der Gehäusedurchführung ergibt, für ein gegebenes Gehäuse fixiert.

Für SAW-Filter nach dem Reaktanzfiltertyp in weiter miniaturisierten Gehäusen ist also auch die Möglichkeit B nicht mehr in ausreichendem Maße gegeben, um die LO- und/oder Imageunterdrückung durch geeignet gesetzte Polstellen über einen großen Frequenzbereich von $f_0$ plus 100-800 MHz zu gewährleisten. Insbesondere bei der zukünftigen Verbindungstechnologie 'Flip-Chip-Technik', bei der statt der Bonddrähte Bumpverbindungen verwendet werden, ist es unmöglich, Polstellen bei relativ niedrigen Frequenzen, also im Bereich von 100 MHz oberhalb der Mittenfrequenz $f_0$ zu erzeugen, da die bei dieser Aufbautechnik vorhandenen Induktivitäten seriell zur Ausgangsseite eines Parallelresonators zu klein sind (siehe Formel 1.5) und die statischen Kapazitäten der Parallelzweige wegen der benötigten Selbstanpassung an 50Ω ebenfalls nicht groß genug gewählt werden können.

Aufgabe der vorliegenden Erfindung ist es daher, einen Weg anzugeben, wie ein Filter so gestaltet werden kann, daß eine verbesserte Sperrbereichsunterdrückung für bestimmte LO- und Image-freqenzen über einen möglichen Bereich von 100 bis 800 MHz neben der Mittenfrequenz erhalten werden kann. Insbesondere soll ein Weg angegeben werden, Polstellen eines Reaktanzfilters ohne größere Einflüsse auf das übrige Filterverhalten in einen gewünschten Bereich nahe der Mittenfrequenz $f_0$ zu verschieben.

Diese Aufgabe wird erfindungsgemäß gelöst mit einem Filter nach Anspruch 1. Vorteilhafte Ausgestaltungen und ein Verfahren zur Verschiebung von Polstellen sind weiteren Ansprüchen zu entnehmen.

Erfindungsgemäß wird durch eine Verbindung der masseseitigen Ausgangsseiten der jeweils einen Resonator aufweisenden Parallelzweige auf dem Chip eine Verkopplung der Parallelzweige erzeugt, wodurch die Frequenzlage der zugehörigen Polstelle (weiterhin auch als 'verkoppelte Polstelle' bezeichnet) in großem Maße verändert werden kann. Dadurch ist es möglich, ein SAW Filter zu erzeugen, das Polstellen bei niedrigeren Frequenzen aufweist, als sie durch die bisherige serielle Verschaltung der Parallelzweige mit den vorhandenen aufbaubedingten Induktivitäten gemäß der Formel (1.5) erreichbar waren. Auch ist es möglich, eine oder mehrere Polstellen bei einem gegebenen Filter über einen weiteren Frequenzbereich zu verschieben, als dies bei einem gegebenen Filter bislang möglich war. So kann mit der Erfindung eine Polstelle exakt bei der Frequenz erzeugt werden, an der eine große Selektion erforderlich ist, beispielsweise bei einer beliebigen LO - oder Imagefrequenz.

Damit können Selektionsanforderungen für die Unterdrückung von Signalen bei der Lokaloszillatorfrequenz (LO Unterdrük kung) und/oder bei der Spiegelfrequenz (Imageunterdrückung) auch in extrem kleinen Gehäusen mit sehr kleinen aufbaubedingten Induktivitäten noch erfüllt werden. So kann bei einer gegebenen Bond-, Leiter- oder Gehäusedurchführungsinduktivität eine oder mehrere Polstellen an eine gewünschte Frequenz verschoben werden, ohne daß es dazu einer Erhöhung der seriellen Induktivität bedarf. Zusätzlich kann natürlich auch noch die serielle Induktivität erhöht werden.

Zudem lassen sich die Anzahl der bereitgestellten Masseanbindungen unabhängig von der Anzahl der verwendeten Parallelzweige einstellen, was zu einem geringeren Platzbedarf führt. Gerade im Hinblick auf neue Verbindungstechnologien (Bumpverbindungen statt Bondverbindungen) und neue Gehäusetechnologien stellen die Ausführungsformen gemäß der Erfindung die einzige Möglichkeit zum Erreichen der oben genannten Selektionsanforderungen in miniaturisierten Gehäusen dar.

Im Gegensatz zu den aus dem Stand der Technik bekannten Maßnahmen wie z.B. in EP-A-0 878 902 ermöglicht der gemäß der Erfindung erreichte Variationsbereich für die Frequenzlage von Polstellen auch bei extrem miniaturisierten Gehäusen die Herstellung von SAW Filtern mit einer für die Anwendung als HF-Filter im Mobilfunkbereich geforderten LO- und Imageunterdrückung.

Im Folgenden soll das Prinzip zur Verschiebung der Polstellen gemäß der vorliegenden Erfindung anhand von Ausführungsbeispielen und der dazugehörigen Figuren näher erläutert werden. Die anschließenden konkreten Ausführungsformen sind Beispiele für die Anwendung in einem SAW-Filter nach dem Reaktanzfiltertyp.

Dabei zeigen

| Fig. 1 | einen Eintor SAW-Resonator |
| Fig. 2 | das Ersatzschaltbild und Symbol für einen SAW-Resonator |
| Fig. 3 | ein Grundglied eines SAW-Filters nach dem Reaktanzfiltertyp |
| Fig. 4 | Zusammenwirken von Parallel- und Serienresonator |
| Fig. 5 | Kaskade zweier Grundglieder |
| Fig. 6 | Kaskade zweier Grundglieder |
| Fig. 7 | Diagramm eines Reaktanzfilters |
| Fig. 8 | Diagramm eines Reaktanzfilters mit der reduzierten Struktur s-p-s-p |
| Fig. 9 | Aufsicht auf ein SAW-Filter im Gehäuse ohne Deckel |
| Fig. 10 | Querschnitt durch ein SAW-Filter im Gehäuse |
| Fig. 11a | Polstelle |
| Fig. 11b | Ersatzschaltbild für das Dämpfungsverhalten eines Parallelzweiges |
| Fig. 12 | Ersatzschaltbild eines Filters |
| Fig. 13 | Ersatzschaltbild für das Dämpfungsverhalten eines SAW-Filters |
| Fig. 14 | Diagramm, das den Zusammenhang zwischen $\Delta L_{ser}$ und Polstelle zeigt |
| Fig. 15 | Abhängigkeit der Frequenzlage der Polstelle von der statischen Kapazität |
| Fig. 16 | Filter mit drei Grundgliedern |
| Fig. 17 | Dessen Ersatzschaltbild im Sperrbereich |
| Fig. 18 | Dessen Dämpfungsverhalten |
| Fig. 19 | Filter mit vier Grundgliedern |
| Fig. 20 | Dessen Ersatzschaltbild im Sperrbereich |
| Fig. 21 | Dessen Dämpfungsverhalten |
| Fig. 22 | Filter mit vier Grundgliedern |
| Fig. 23 | Dessen Ersatzschaltbild im Sperrbereich |
| Fig. 24 | Dessen Dämpfungsverhalten |
| Fig. 25 | Filter mit vier Grundgliedern |
| Fig. 26 | Dessen Ersatzschaltbild im Sperrbereich |
| Fig. 27 | Dessen Filtercharakteristik |
| Fig. 28 | Filter mit vier Grundgliedern |
| Fig. 29 | Dessen Ersatzschaltbild im Sperrbereich |
| Fig. 30 | Filterstruktur mit Bumpverbindung |
| Fig. 31 | Filterstruktur mit Bondverbindung |

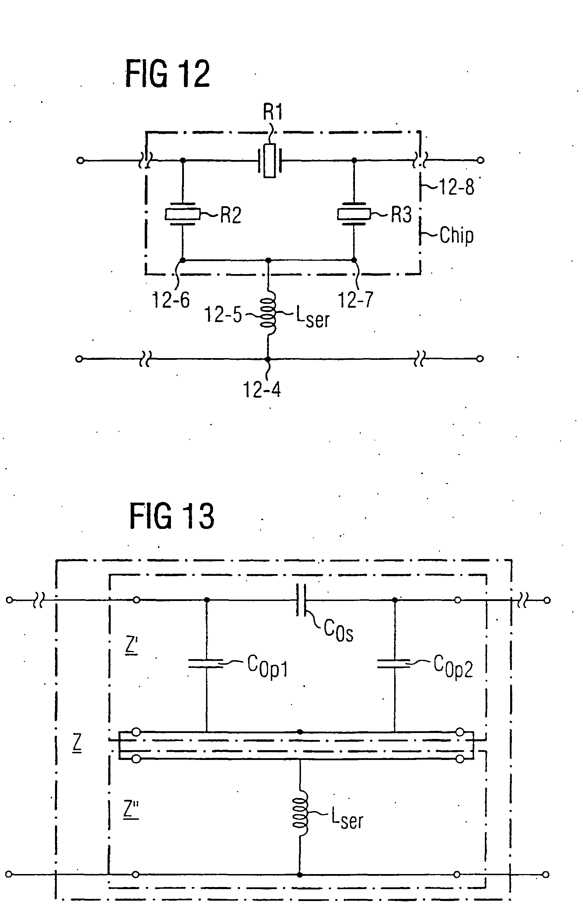

In Fig.12 ist eine einfache Filterstruktur, die Ausschnitt einer größeren Filterstruktur mit weiteren Grundgliedern sein kann, symbolisch als Ersatzschaltbild dargestellt. Bei (mindestens) zweien der Parallelzweige mit den Parallelresonatoren R2 und R3 werden bereits auf dem Chip (Substrat) 12-8 die Ausgangsseiten 12-6 und 12-7 elektrisch miteinander verbunden. Erst anschließend folgt eine z.B. eine Bondverbindung 12-5 umfassende Verbindung zum Gehäusemassepad 12-4.

In Fig. 13 ist das Ersatzschaltbild für den Frequenzbereich $f<<f_0$ und $f>>f_0$, in dem bei jedem Resonator nur seine statische Kapazität $C_0$ wirkt, dargestellt. Das Selektionsverhalten eines SAW-Filters nach dem Reaktanzfiltertyp kann weitgehend mit diesem reduzierten Ersatzschaltbild beschrieben werden. Die Induktivität $L_{ser}$ entspricht einer Induktivität zwischen der Verbindung der Parallelresonatoren auf dem Chip und dem Gehäusemassepin (=Anschluß für Masse am Gehäuse) außen.

Es kommt zu einer Verkopplung der beiden bereits auf dem Chip elektrisch verbundenen Parallelzweige. Dies führt zu einer Frequenzlagenänderung der Polstellen im Sperrbereich. Anhand des Ersatzschaltbildes aus Fig. 13, das ein Zweitor Z darstellt, läßt sich die Frequenzlage der verkoppelten Polstelle bestimmen. Das Zweitor Z weist dann eine Polstelle auf, wenn die Impedanz gegen Masse zu Null wird.

$$Z_{21} = 0$$

$Z_{21}$ ist dabei ein systematisch bezeichnetes Matrixelement aus der Impedanzmatrix. Zur Bestimmung von $Z_{21}$ kann

das Zweitor Z in eine Reihenschaltung der Zweitore Z' und Z" aufgeteilt werden. Das Zweitor Z' umfaßt die $\Pi$-Schaltung aus den drei Kapazitäten $C_{0p1}$, $C_{0p2}$ und $C_{0s}$. Das Zweitor Z" umfaßt nur die Induktivität $L_{ser}$. Damit ergibt sich

$$Z'_{21} = \frac{1}{j\omega\left(C_{0p2} + C_{0p1} + \dfrac{C_{0p1}C_{0p2}}{C_{0s}}\right)} \tag{2.1}$$

$$Z''_{21} = j\omega L_{ser} \tag{2.2}$$

Wobei j= die imaginäre Zahl darstellt
und $\omega = 2\pi f$
Mit

$$Z_{21} = Z'_{21} + Z''_{21} \tag{2.3}$$

folgt

$$Z_{21} = \frac{1 - \omega^2 L_{ser}\left(C_{0p2} + C_{0p1} + \dfrac{C_{0p1}C_{0p2}}{C_{0s}}\right)}{j\omega\left(C_{0p2} + C_{0p1} + \dfrac{C_{0p1}C_{0p2}}{C_{0s}}\right)} \tag{2.4}$$

Wird der Zähler des Ausdrucks von (2.4) zu Null

$$1 - \omega^2 L_{ser}\left(C_{0p2} + C_{0p1} + \frac{C_{0p1}C_{0p2}}{C_{0s}}\right) = 0 \tag{2.5}$$

wird $Z_{21}$ zu Null. Daraus erhält man für die Frequenzlage der verkoppelten Polstelle

$$f_{pol \text{ (verkoppelt)}} = \frac{1}{2\pi\sqrt{L_{ser}\left(C_{0p2} + C_{0p1} + \dfrac{C_{0p1}C_{0p2}}{C_{0s}}\right)}} \tag{2.6}$$

Im Vergleich zu den bisher ohne Verkopplung der Parallelzweige auf dem Chip erhaltenen Polstellen gemäß Formel (1.5)

$$f_{pol1} = \frac{1}{2\pi\sqrt{L_{ser} * C_{0p1}}} \tag{2.7}$$

und

$$f_{pol2} = 1 \bigg/ 2\pi\sqrt{L_{ser} * C_{0p2}} \qquad (2.8)$$

ist deutlich ersichtlich, daß die zusätzlichen Kapazitätsanteile $\frac{C_{0p1}C_{0p2}}{C_{0s}}$ und $C_{0p2}$ bzw. $C_{0p1}$ die verkoppelte Polstelle bei gleicher Induktivität $L_{ser}$ zu einer weit niedrigeren Frequenz verschiebt.

Zahlenbeispiel: Für ein bekanntes SAW Filter vom Reaktanzfiltertyp errechnet sich die Frequenz $f_{pol}$ einer Polstelle zu

$$f_{pol}1 = 1 \bigg/ 2\pi\sqrt{L_{ser} * C_{0p1}} = 1 \bigg/ 2\pi\sqrt{1nH * 4pF} = 2,52 \text{ GHz}$$

Dabei wurden für die serielle Induktivität $L_{ser}$ und für die statische Kapazität $C_{0p}$ typische Werte von 1nH und 4pF angenommen.

Werden zwei Parallelzweige verkoppelt, ergibt sich gemäß Formel 2.6 bei den gleichen angenommenen Werten für $L_{ser}$ und $C_{0p}$ und bei ebenso 4pF für $C_{0s}$

$$f_{pol}2 = 1 \bigg/ 2\pi\sqrt{1nH * (4pF + 4pF + (4pF)^2/4pF)} = 1,45 \text{ GHz}$$

Weist ein Filter mehrere Parallelzweige auf, so können auch mehrere Parallelzweige masseseitig miteinander verbunden werden, die weiterhin auch als 'verkoppelte Parallelzweige' bezeichnet werden. Für die Frequenzlage der verkoppelten Polstellen spielt die Anzahl und Kombination der verbundenen Parallelzweige eine entscheidende Rolle und ist bei der Auswahl der Filterstruktur für eine gewünschte Frequenzlage der Polstellen zu berücksichtigen.

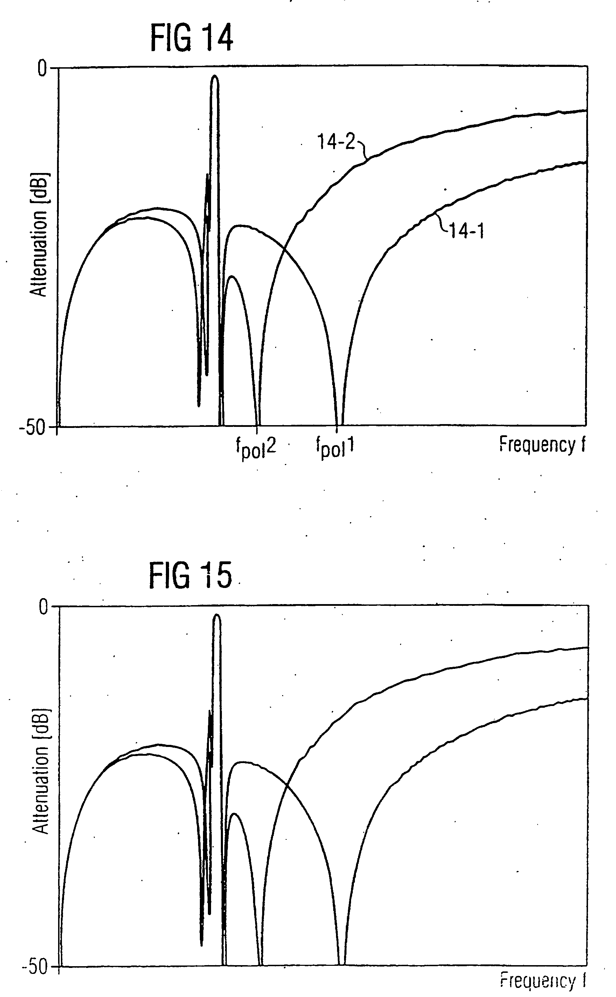

Fig. 14 gibt die Abhängigkeit der Lage einer verkoppelten Polstelle von der Größe der Induktivität $L_{ser}$ an. Die beiden Kurven 14-1 und 14-2 geben das Filterverhalten für das gleiche Filter an, wobei lediglich $L_{ser}$ unterschiedlich gewählt ist. Es ergibt sich abhängig von $L_{ser}$ eine unterschiedliche Frequenzlage der Polstellen, wobei die zu $f_{pol}1$ gehörende Induktivität $L_{ser}1$ kleiner ist als $L_{ser}2$. Je größer die Induktivität $L_{ser}$ ist, desto größer ist die Verschiebung der Polstelle zu niedrigeren Frequenzen hin.

In kleinerem Maße läßt sich die Frequenzlage der Polstelle durch eine Variation des Produkts aus den statischen Kapazitäten der verkoppelten Parallelzweige

$$\Pi C_p = C_{0p1} * C_{0p2} \qquad (2.9)$$

einstellen. Um das Filterverhalten im Passband und das allgemeine Selektionsniveau nicht zu verändern, kann eine solche Variation des Produkts aus den statischen Kapazitäten im Parallelzweig nur unter Beibehaltung ihrer Summe

$$\Sigma C_p = C_{0p1} + C_{0p2} = \text{constant} \qquad (2.10)$$

durchgeführt werden.

Es kann folgende Methode angewandt werden: die statische Kapazität $C_{0p1}$ des ersten verkoppelten Parallelresonators wird um denselben Betrag $C_{const}$ erhöht

$$C_{op1}(\text{neu}) = C_{0p1} + C_{const} \qquad (2.11)$$

wie die statische Kapazität $C_{0p2}$ des zweiten verkoppelten Parallelresonators erniedrigt wird,

$$C_{op2}(neu) = C_{0p2} - C_{const} \text{ mit } C_{const} < C_{0p2} \qquad (2.12)$$

so daß sich zwar das Produkt $\Pi C_p$ ändert, die Summe der statischen Kapazitäten aber identisch bleibt

$$\Sigma C_p = C_{op1}(neu) + C_{op2}(neu) = C_{0p1} + C_{0p2} = constant \qquad (2.13)$$

und keine Veränderungen des Passbandes oder des allgemeinen Selektionsniveaus in Kauf genommen werden müssen.

Ist ein größerer Frequenzversatz der verkoppelten Polstelle notwendig, können die beteiligten statischen Kapazitäten $C_{0p1}$, $C_{0p2}$ oder $C_{0s}$ variiert werden. Sind mehr Parallelresonatoren als die zwei zu verkoppelnden Parallelresonatoren vorhanden, so kann die Summe $C_{0p1}+C_{0p2}$ erhöht (oder erniedrigt) werden und zum Ausgleich die statische Kapazität eines nicht verkoppelten Parallelresonators derart erniedrigt (oder erhöht) werden, daß die Gesamtsumme aller statischen Kapazitäten in den Parallelzweigen gleich bleibt. Dadurch wird das allgemeine Selektionsniveau beibehalten.

Fig. 15 zeigt, wie bei konstanter Induktivität $L_{ser}$ durch eine Veringerung der Summe der statischen Kapazitäten $C_{0p1}+C_{0p2}$ der verkoppelten Parallelzweige um den Faktor 1.2 die Frequenz der verkoppelten Polstelle erhöht wird. Zum Ausgleich wurde die statische Kapazität eines weiteren Parallelzweiges entsprechend erhöht.

Eine weitere Möglichkeit zur Verschiebung der verkoppelten Polstelle besteht darin, einen Parallelresonator P bewußt aufzusplitten in zwei einzelne zueinander parallele Resonatoren P' und P'', wobei die Summe der Kapazitäten der aufgesplitteten einzelnen Resonatoren gleich der ursprünglichen Kapazitäten $C_{0p}$ ist:

$$C_{0p} = C'_{0p} + C''_{0p}.$$

Wird einer dieser Parallelresonatoren P' mit einem weiteren Parallelresonator verkoppelt, nicht jedoch mit dem Parallelresonator P'', so kann die Frequenzlage der verkoppelten Polstelle anhand des Teilungsverhältnisses $\frac{C'_{0p}}{C''_{0p}}$ der statischen Kapazität der aufgesplitteten Parallelresonatoren P' und P'' eingestellt werden, da nur $C'_{0p}$ einen Einfluß auf die Frequenzlage der verkoppelten Polstelle hat.

Zwischen verkoppelten Parallelzweigen kann ein einzelner oder mehrere Serienresonatoren angeordnet sein. Da auch din Größe der statischen Kapazität $C_{0s}$, die zwischen den verkoppelten Parallelresonatoren liegt, die Frequenzlage der verkoppelten Polstelle gemäß Formel 2.6 beeinflußt, kann mit folgender Methode ebenfalls die Frequenzlage der verkoppelten Polstelle verschoben werden.

Sind weitere Serienresonatoren $S_n$ außer dem oder den zwischen den verkoppelten Parallelzweigen liegenden Serienresonator S vorhanden, so kann dessen statische Kapazität $C_{0s}$ erhöht (oder erniedrigt) und zum Ausgleich die statische Kapazität der nicht zwischen den verkoppelten Parallelresonatoren liegenden Serienresonatoren $S_n$ derart erniedrigt (oder erhöht) werden, daß die Gesamtsumme aller statischen Kapazitäten in den Serienzweigen gleich bleibt. Dadurch wird das allgemeine Selektionsniveau beibehalten und die Frequenzlage der verkoppelten Polstelle verändert.

Wie bereits erläutert ist der Bereich für die Variation der statischen Kapazitäten $C_p$ im Parallelzweig und der seriellen Induktivitäten $L_{ser}$ (zwischen der Verbindung der Parallelzweige auf dem Chip und dem Außenanschluß am Gehäuse) begrenzt. Gleiches gilt daher auch für den Frequenzbereich, in dem die Polstellen verschoben werden können.

Man verwendet eine Struktur mit drei Grundgliedern. An das Eingangstor 16-1 ist ein erstes Grundglied derart angeschlossen, daß sowohl der Parallelzweig als auch der Serienzweig eine Verbindung zum Eingangstor aufweisen. Das zweite Grundglied wird gemäß der Anpassungsforderung $Z_{aus}=Z_{ein}$ angeschlossen. In der gleichen Weise folgt das dritte Grundglied. Mit dem Ausgangstor ist somit anders wie am Eingangstor nur ein Serienzweig direkt verbunden. Vom Eingang zum Ausgang ergibt sich eine Abfolge *p-s - s-p - p-s* für die Resonatoren, wobei *p* für Parallelresonator und s für Serienresonator steht. Prinzipiell können Ein- und Ausgangstor vertauscht werden, ohne die Filtereigenschaften zu ändern, wobei sich die Reihenfolge s-*p-p-s-s-p* ergibt.

Wie bekannt können gleichartige Resonatoren unter Beibehaltung ihrer kapazitiven Wirkung auch zusammengefaßt werden. Damit ergeben sich folgende Strukturen mit minimaler Resonatorzahl:

*p-s-p-s*    bzw.    *s-p-s-p*

aber auch Zwischenformen mit teilweisem Zusammenfassen der Resonatoren sind möglich:

*p-s-p-p-s*      bzw.         *s-p-p-s-p*
*p-s-s-p-s*      bzw.         *s-p-s-s-p*

Der Einfachheit halber werden die Filterbeispiele im folgenden nur noch anhand von minimaler Resonatorzahl und ohne zusätzlichen Hinweis auf die Vertauschbarkeit von Ein- und Ausgangstor erklärt und in den Figuren dargestellt.

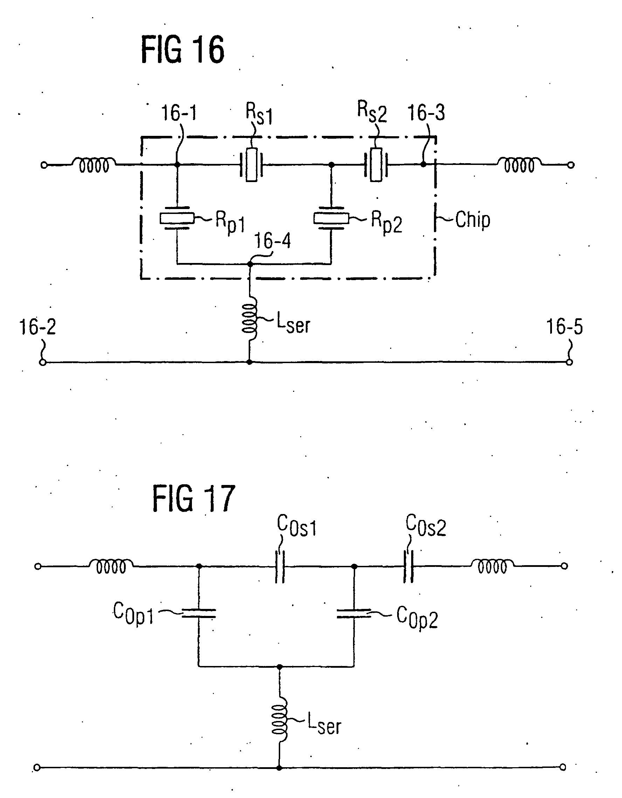

In Fig. 16 ist ein Ladder-Type-Filter symbolisch dargestellt. Die beiden Parallelzweige werden bereits auf dem Chip elektrisch miteinander verbunden und erst anschließend folgt eine Verbindung zum Gehäuse. Das Ersatzschaltbild für das Selektionsverhalten im Bereich $f \ll f_0$ und $f \gg f_0$ ist in Fig. 17 dargestellt. Die Induktivität $L_{ser}$ entspricht einer Induktivität zwischen der Verbindung der Parallelresonatoren auf dem Chip und dem Gehäusemassepin außen.

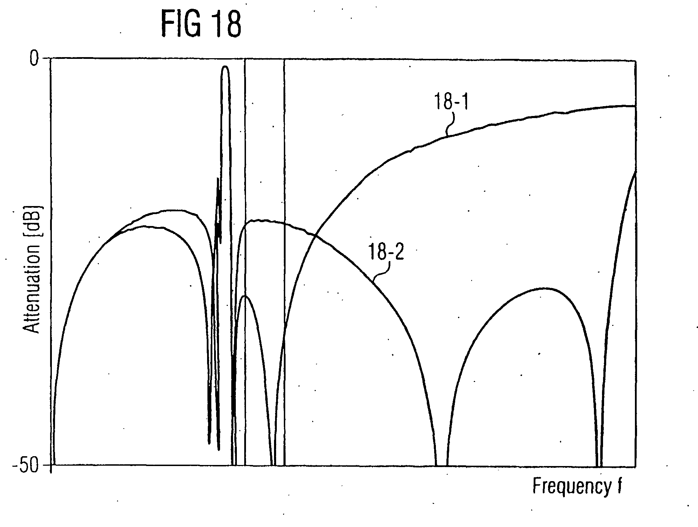

Das Filter hat eine Filtercharakteristik, die durch Kurve 18-1 in Fig. 18 gekennzeichnet ist. Der Vergleich mit der Filterkurve 18-2 (entspricht dem in Fig. 8 dargestellten Filter), bei der die Parallelzweige auf dem Chip nicht verbunden sind, zeigt deutlich, wie durch das Verbinden der Parallelzweige auf dem Chip die Frequenzlage der Polstellen im Sperrbereich mit einer typischen Induktivität $L_{ser}$ = 1.0nH verschoben wird. Im Frequenzbereich zwischen den senkrechten Linien (typischer Frequenzbereich für LO- und Imageunterdrückung bei niedriger ZF-Frequenz) wird die Selektion um mehr als 10 dB erhöht.

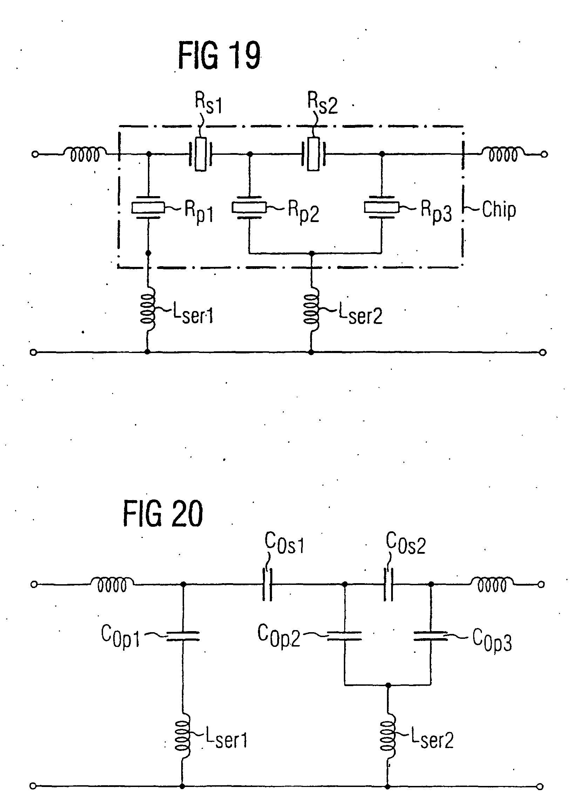

In Fig.19 ist die Struktur symbolisch dargestellt, bei der eine Struktur mit vier Grundgliedern verwendet wird. An das Eingangstor 19-1 ist ein erstes Grundglied derart angeschlossen, daß sowohl der Parallelzweig als auch der Serienzweig eine Verbindung zum Eingangstor aufweisen. Das zweite Grundglied wird gemäß der Anpassungsforde-rung $Z_{aus} = Z_{ein}$ angeschlossen. In der gleichen Weise folgen Grundglied drei und vier. Mit dem Ausgangstor 19-3 sind somit ebenso wie am Eingangstor sowohl ein Parallelzweig als auch ein Serienzweig direkt verbunden. Vom Eingang zum Ausgang ergibt sich eine Abfolge für die Resonatoren wie folgt:

*p-s-p-s-p*

wobei *p* für Parallelresonator und *s* für Serienresonator steht. Resonatoren gleichen Typs sind bereits zusammengefaßt.

Zwei der drei Parallelzweige werden bereits auf dem Chip elektrisch miteinander verbunden und erst anschließend folgt über die Induktivität $L_{ser2}$ eine Verbindung zum Gehäuse. Der verbleibende Parallelzweig wird unabhängig davon über die Induktivität $L_{ser1}$ mit dem Gehäuse verbunden. Das Ersatzschaltbild für das Selektionsverhalten im Bereich $f \ll f_0$ und $f \gg f_0$ ist in Fig.20 dargestellt. Die Induktivität $L_{ser2}$ entspricht einer Induktivität zwischen der Verbindung 19-4 der Parallelresonatoren auf dem Chip (in der Figur durch die gestrichelte Linie dargestellt) und dem Gehäusemassepin außen.

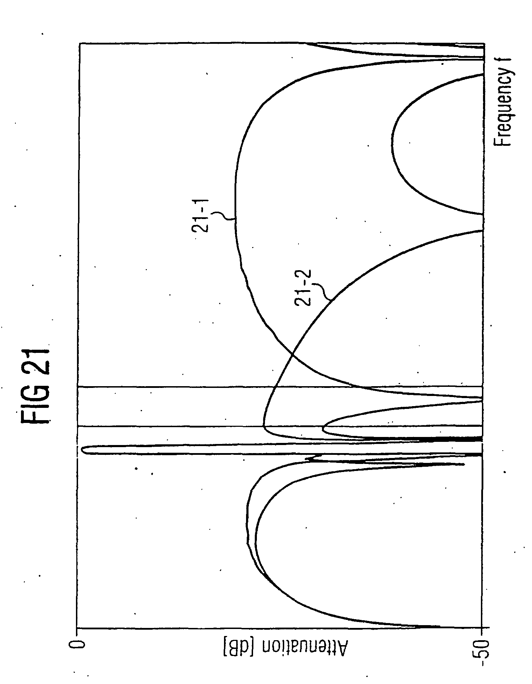

In Fig. 21 zeigt die Kurve 21-1 die Filtercharakteristik des Filters aus Fig.19. Der Vergleich mit der Filterkurve 21-2, bei der die Parallelzweige auf dem Chip nicht verbunden sind, zeigt deutlich, wie durch das Verbinden von hier zwei der drei Parallelzweige auf dem Chip die Frequenzlage der Polstellen im Sperrbereich bei einer typischen Induk-tivität $L_{ser2}$ = 1.0nH zu niedrigeren Frequenzen verschoben wird. Im Frequenzbereich zwischen den senkrechten Linien (typischer Frequenzbereich für LO- und Imageunterdrückung bei niedriger ZF-Frequenz) wird die Selektion um ca 10 dB erhöht.

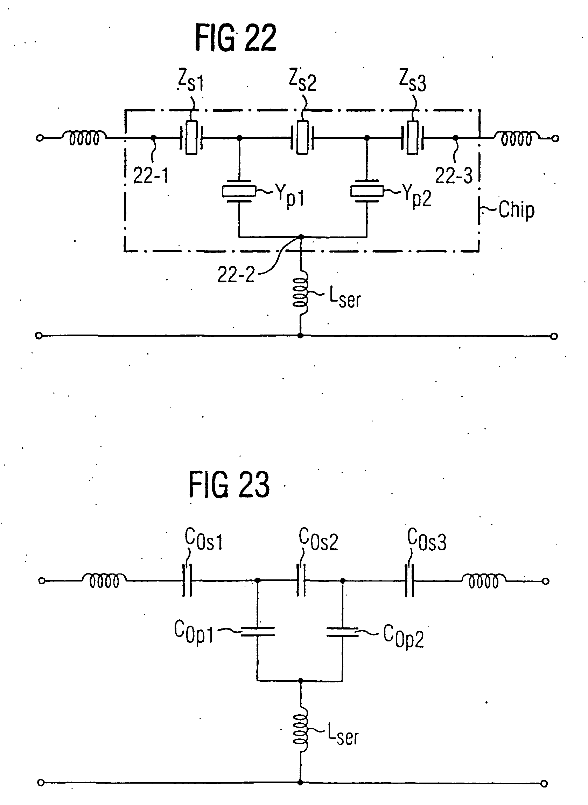

In Fig. 22 ist eine weitere Struktur symbolisch dargestellt. Man verwendet eine Struktur mit vier Grundgliedern. An das Eingangstor 22-1 ist ein erstes Grundglied derart angeschlossen, daß nur der Serienzweig eine Verbindung zum Eingangstor aufweist. Das zweite Grundglied wird gemäß der Anpassungsforderung $Z_{aus} = Z_{ein}$ angeschlossen. In der gleichen Weise folgen Grundglied drei und vier. Mit dem Ausgangstor 22-3 ist somit ebenso wie am Eingangstor nur ein Serienzweig direkt verbunden. Vom Eingang zum Ausgang ergibt sich eine Abfolge für die Resonatoren wie folgt:

*s-p-s-p-s*

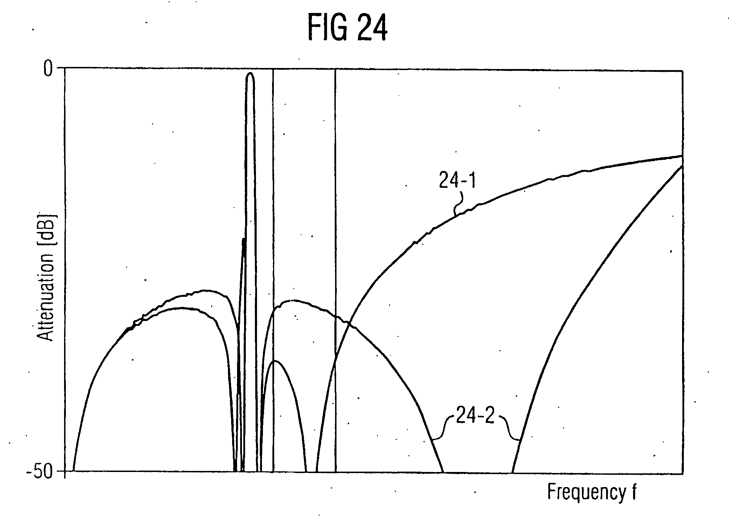

wobei *p* für Parallelresonator und *s* für Serienresonator steht. Resonatoren gleichen Typs sind bereits zusammengefaßt. Die zwei Parallelzweige werden bereits auf dem Chip elektrisch miteinander verbunden und erst anschließend folgt eine Verbindung zum Gehäuse. Das Ersatzschaltbild für das Selektionsverhalten im Bereich $f \ll f_0$ und $f \gg f_0$ ist in Fig. 23 dargestellt. Die Induktivität $L_{ser}$ entspricht einer Induktivität zwischen der Verbindung der Parallelresonatoren auf dem Chip und dem Gehäusemassepin außen. Das Filter aus Fig. 22 hat eine Filtercharakteristik, die durch Kurve 24-1 in Fig. 24 gekennzeichnet ist. Der Vergleich mit der Filterkurve 24-2, bei der die Parallelzweige auf dem Chip nicht verbunden sind, zeigt deutlich, wie durch das Verbinden von den zwei Parallelzweigen auf dem Chip die Frequenzlage der Polstellen im Sperrbereich bei einer typischen Induktivität $L_{ser}$ = 1.0nH verschoben wird. Im Frequenzbereich zwischen den senkrechten Linien (typischer Frequenzbereich für LO- und Imageunterdrückung bei hoher ZF-Frequenz) wird die Selektion um mehr als 8 dB erhöht.

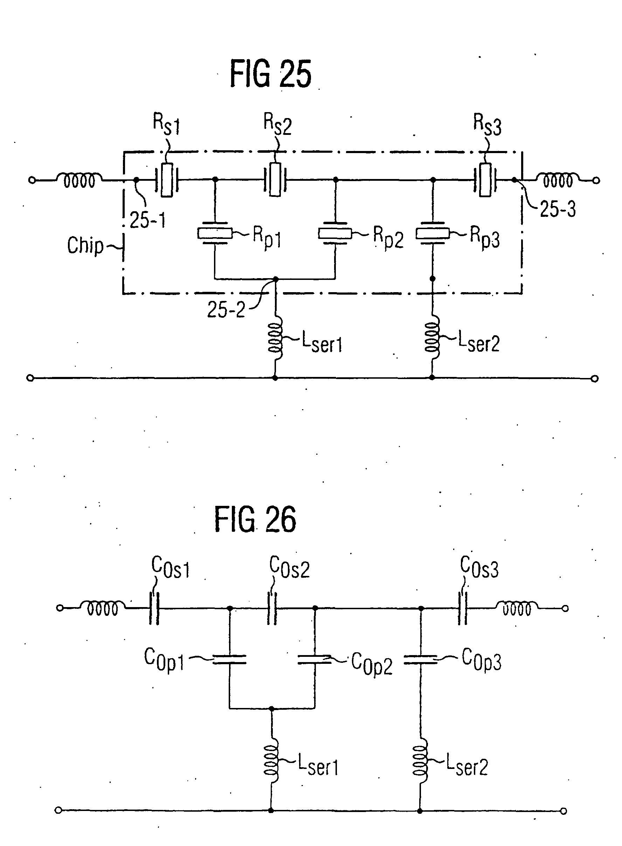

**Ausführungsform 1 (siehe auch Fig.25 - Fig.27):**

In Fig. 25 ist die Struktur der erfindungsgemäßen Ausführungsform 1 symbolisch dargestellt. Man verwendet eine Struktur mit vier Grundgliedern. An das Eingangstor 25-1 ist ein erstes Grundglied derart angeschlossen, daß nur der Serienzweig mit dem Resonator $R_{S1}$ eine Verbindung zum Eingangstor aufweist. Das zweite Grundglied wird gespiegelt angeschlossen wegen der Anpassungsforderung $Z_{aus}=Z_{ein}$. In der gleichen Weise folgen Grundglied drei und vier. Mit dem Ausgangstor 25-3 ist somit ebenso wie am Eingangstor nur ein Serienzweig direkt verbunden. Vom Eingang zum Ausgang ergibt sich eine Abfolge für die Resonatoren wie folgt:

s-p-s-p-p-s

Resonatoren gleichen Typs sind bereits zusammengefaßt, im Gegensatz zur Ausführungsform 3 ist jedoch ein Parallelzweig bewußt wieder aufgeteilt. Die Aufteilung erfolgt so, daß jeder Parallelresonator $R_{p2}$, $R_{p3}$ ein eigenes Zweitor mit eigenen elektrischen Ein- und Ausgängen bildet. Der zusammengefaßte Parallelzweig mit dem Resonator $R_{p1}$ wird mit einem der nicht zusammengefaßten zwei Parallelzweige ($R_{p2}$) bereits auf dem Chip am Punkt 25-2 elektrisch miteinander verbunden und erst anschließend folgt über $L_{ser1}$ eine Verbindung zum Gehäuse. Der verbleibende Parallelzweig ($R_{p3}$) wird unabhängig davon mit dem Gehäuse verbunden. Das Ersatzschaltbild für das Selektionsverhalten im Bereich $f<<f_0$ und $f>>f_0$ ist in Fig. 26 dargestellt. Die Induktivität $L_{ser1}$ entspricht einer Induktivität zwischen der Verbindung der Parallelresonatoren $Rp_1$ und $Rp_2$ auf dem Chip und dem Gehäusemassepin außen, die Induktivität $L_{ser2}$ entspricht einer Induktivität zwischen dem Parallelresonator $R_{p3}$ auf dem Chip und dem Gehäusemassepin außen

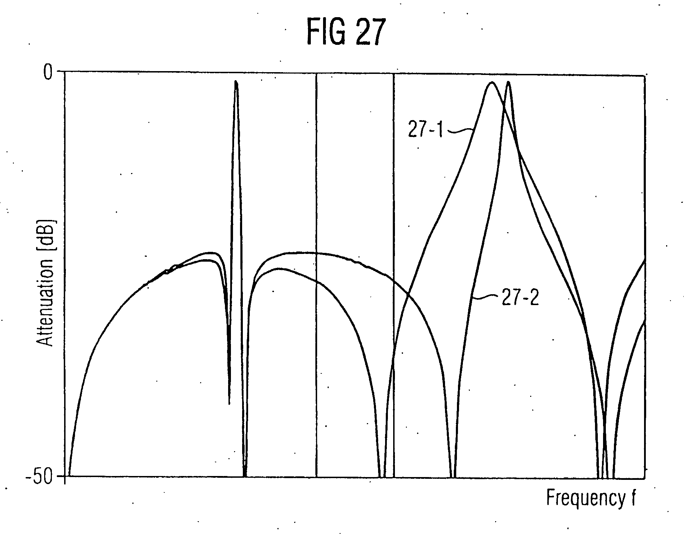

Das Filter aus Fig. 25 hat eine Filtercharakteristik, die durch Kurve 27-1 in Fig. 27 gekennzeichnet ist. Der Vergleich mit der Filterkurve 27-2, bei der die Ausgangsseiten der Parallelzweige auf dem Chip nicht verbunden sind, zeigt deutlich, wie durch das Verbinden von zwei der drei Parallelzweigen auf dem Chip die Frequenzlage der Polstellen im Sperrbereich bei einer typischen Induktivität $L_{ser1}$ = 1.0nH verschoben wird. Im Frequenzbereich zwischen den senkrechten Linien (typischer Frequenzbereich für LO- und Imageunterdrückung bei hoher ZF-Frequenz) wird die Selektion um allgemein mehr als 5 dB erhöht. Wird entweder eine hohe LO- oder Imageunterdrückung verlangt, ist der Selektionsgewinn weit mehr als 10 dB.

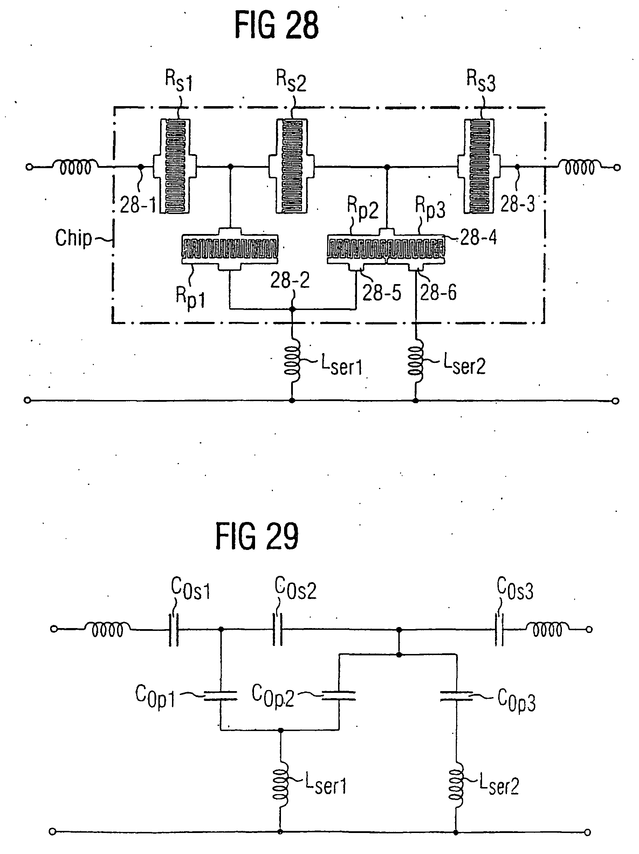

**Ausführungsform 2 (siehe auch Fig.28 - Fig.30):**

In Fig. 28 ist die Struktur der erfindungsgemäßenm Ausführungsform 2 symbolisch dargestellt. Man verwendet eine Struktur mit vier Grundgliedern. An das Eingangstor 28-1 ist ein erstes Grundglied derart angeschlossen, daß nur der Serienzweig eine Verbindung zum Eingangstor aufweist. Das zweite Grundglied wird gemäß der Anpassungsforderung $Z_{aus}=Z_{ein}$ angeschlossen. In der gleichen Weise folgen Grundglied drei und vier. Mit dem Ausgangstor 28-3 ist somit ebenso wie am Eingangstor nur ein Serienzweig direkt verbunden. Vom Eingang zum Ausgang ergibt sich eine Abfolge für die Resonatoren wie folgt:

s-p-s-p-p-s

Resonatoren gleichen Typs sind bereits zusammengefaßt, ähnlich wie bei der Ausführungsform 1 ist jedoch ein Parallelzweig bewußt wieder aufgeteilt. Die Aufteilung erfolgt aber nicht in zwei voneinander unabhängige Parallelresonatoren, sondern vielmehr in Form eines Dreitores. Der Eingang für beide Parallelresonatoren besteht aus einer gemeinsamen Anschlußleiste 28-4, an der die anregenden Interdigitalfinger liegen. Die Anschlußleiste des Ausgangs ist in zwei Busbars 28-5 und 28-6 aufgeteilt, wobei jeder Busbar dem Ausgang eines der beiden Parallelresonatoren entspricht.

Der Parallelzweig mit dem Resonator $R_{p1}$ wird mit einem der nicht zusammengefaßten Parallelresonatoren $R_{p2}$ bereits auf dem Chip am Masseausgang 28-2 elektrisch miteinander verbunden. Erst anschließend erfolgt eine Verbindung zum Gehäuse. Der verbleibende Parallelzweig mit dem Parallelresonator $R_{p3}$ wird unabhängig davon mit dem Gehäuse verbunden. Das Ersatzschaltbild für das Selektionsverhalten im Bereich $f<<f_0$ und $f>>f_0$ ist in Fig.29 dargestellt. Es ist prinzipiell vergleichbar mit dem Ersatzschaltbild in Fig. 26. Die Induktivität $L_{ser1}$ entspricht einer Induktivität zwischen der Verbindung der Parallelresonatoren $R_{p1}$ und $R_{p2}$ auf dem Chip und dem Gehäusemassepin außen, die Induktivität $L_{ser2}$ einer weiteren Induktivität zwischen dem nicht verkoppelten Resonator $R_{p3}$ und dem Gehäusemassepin außen.

Das Filter aus Fig. 28 hat eine Filtercharakteristik, die sich von dem Filter aus Fig. 26 nicht unterscheidet und daher auch durch Kurve 27-1 in Fig. 27 gekennzeichnet ist. Im Gegensatz zur Ausführungsform 1 wird hier eine andere Form der Aufteilung eines Parallelresonators gezeigt, die sich wesentlich im Layout, aber nicht in der Wirkung auf das Selektionsverhalten unterscheidet.

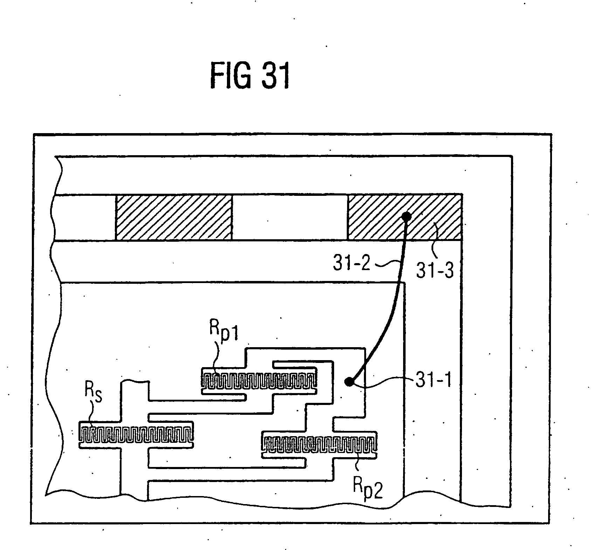

Figur 31 zeigt ausschnittsweise eine erfindungsgemäße Filterstruktur als schematischen Draufblick auf ein Substrat. Die Resonatoren R sind als Interdigitalwandler dargestellt. Die beiden verkoppelten Resonatoren $R_p1$ und $R_p2$ im Parallelzweig sind auf dem Substrat elektrisch miteinander verbunden und weisen eine gemeinsame Masseanbindung 31-1 auf, die durch einen Bonddraht 31-2, der einen Teil der Induktivität $L_{ser}$ darstellt, mit einer Masseanschlußfläche 31-3 verbunden ist. Die Verbindung auf dem Substrat ist hier durch eine Streifenleitung realisiert, kann aber auch einen Bonddraht umfassen. Obwohl hier nur zwei verkoppelte Resonatoren dargestellt sind, umfaßt die Erfindung auch Filter mit mehr als zwei verkoppelten Resonatoren.

**Ausführungsform 3:**

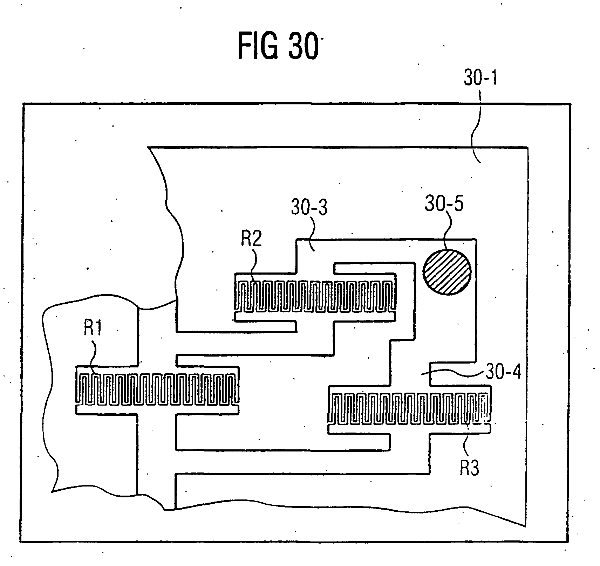

Es folgt nun die Beschreibung einer dritten Ausführungsform gemäß der vorliegenden Erfindung, die in Fig. 30 ausschnittsweise dargestellt ist. Man verwendet ein SAW-Filter nach dem Reaktanzfiltertyp mit mindestens zwei Parallelzweigen. Bei mindestens zwei aller vorhandenen Parallelzweige R2 und R3 werden bereits auf dem Chip elektrisch die Ausgangsseiten (30-3 und 30-4) der Parallelresonatoren elektrisch miteinander verbunden. Erst anschließend folgt eine Verbindung 30-5 zum Gehäuse. Die verbleibenden Parallelzweige werden unabhängig davon mit dem Gehäuse verbunden. Die Verbindung des Chips (30-1) zum Gehäuse ist nicht wie bisher als Bondverbindung ausgeführt, sondern wird durch eine Bumpverbindung (30-5) hergestellt.

Das Ersatzschaltbild für das Selektionsverhalten im Bereich $f<<f_0$ und $f>>f_0$ hat sich gegenüber dem allgemeinen Ausführungsbeispiel nicht verändert und ist aus Fig. 13 ersichtlich. Die Induktivität $L_{ser}$ entspricht einer Induktivität zwischen der Verbindung der Parallelresonatoren auf dem Chip und dem Gehäusemassepin außen. Bei einem Aufbau in der Bumptechnologie ist der Wert für die Induktivität $L_{ser}$ gegenüber einer Ausführung mit Bonddraht stark reduziert, da die Bumpverbindung selbst im Gegensatz zu einer Bondverbindung nahezu keine Induktivität besitzt. Es verbleiben noch der induktive Anteil der Streifenleitung auf dem Chip und die Gehäusedurchführungsinduktivität bis zum externen Gehäusemassepin.

Prinzipiell lassen sich alle bisher gezeigten Ausführungsformen und auch solche mit mehr als vier Grundgliedern mit mindestens zwei bereits auf dem Chip elektrisch verbundenen Parallelzweigen an der Ausgangsseite in Verbindung mit der Bumptechnologie realisieren. Die Filtercharakteristiken sind prinzipiell auch vergleichbar, jedoch ist der für die serielle Induktivität $L_{ser}$ erreichbare Wert geringer. Um die geforderten Selektionen z.B. im Bereich der LO- und/oder Imageunterdrückung zu erzielen, ist es um so mehr notwendig, die erfindungsgemäße Methode zur gezielten Variation des Sperrbereichs zu verwenden. Die Erfindung bietet außerdem den Vorteil, die Anzahl der notwendigen Massebumps und damit die Chipfläche für Masseanschlüsse zu reduzieren. Dadurch kann das gesamte SAW-Filter noch weiter miniaturisiert werden.

**Patentansprüche**

**1.** SAW-Filter nach dem Reaktanzfiltertyp,

- mit einem seriellen Zweig, in dem zumindest ein Serienresonator ($R_{s2}$) angeordnet ist,
- mit einem ersten und einem zweiten parallelen Zweig, wobei der erste und der zweite parallele Zweig an unterschiedlichen elektrischen Knoten an den seriellen Zweig angeschlossen sind, wobei die parallelen Zweige gegen Bezugspotential geschaltet sind,
- wobei in jedem parallelen Zweig ein Parallelresonator (Rp) angeordnet ist,
- wobei der serielle Zweig und die parallelen Zweige auf einem piezoelektrischen Substrat ausgebildet sind,
- wobei das Filter elektrisch mit einem Gehäuse verbindbar ist,
- wobei der im ersten parallelen Zweig angeordnete Parallelresonator in zwei Teilresonatoren ($R_{p2}$, $R_{p3}$) aufgeteilt ist, sodass

  - die beiden Teilresonatoren ein elektrisches Dreitor bilden, das eingangsseitig eine gemeinsame Anschlussleiste (28-4) und ausgangsseitig zwei getrennte Busbars (28-5, 28-6) aufweist, wobei jeder Busbar dem Ausgang eines der beiden Teilresonatoren entspricht, oder
  - sodass die beiden Teilresonatoren zwei elektrische Zweitore mit eingangsseitig und ausgangsseitig getrennten Busbars ausbilden,

  - wobei einer der Teilresonatoren des ersten parallelen Zweigs ($R_{p2}$) und der im zweiten parallelen Zweig angeordnete Parallelresonator ($R_{p1}$) gekoppelte Resonatoren sind, die durch eine auf dem Substrat ausgebildete elektrische Verbindung der Masseseiten miteinander gekoppelt sind, wobei die elektrische Verbindung der Masseseiten vor der Anbindung an das Gehäuse erfolgt.

**2.** SAW-Filter nach Anspruch 1,
bei welchem die elektrische Verbindung eine Streifenleitung auf dem Substrat umfaßt.

**3.** SAW-Filter nach Anspruch 1 oder 2,
bei welchem die elektrische Verbindung eine Bondverbindung zwischen zwei Pads auf dem Substrat umfaßt.

**4.** SAW-Filter nach einem der Ansprüche 1 bis 3,
bei welchem die Gehäuseanbindung der elektrisch verbundenen Masseseiten (12-6, 12-7) des Teilresonators und des mit diesem elektrisch an der Masseseite verbundenen Parallelresonators eine Bumpverbindung (30-5) umfaßt.

**5.** SAW-Filter nach einem der Ansprüche 1 bis 4,
bei welchem die Gehäuseanbindung der elektrisch verbundenen Masseseiten der gekoppelten Resonatoren eine Bondverbindung umfaßt.

**6.** SAW-Filter nach einem der Ansprüche 1 bis 5,
welches durch Flip-Chip-Technik in ein Gehäuse eingebaut ist.

**7.** SAW-Filter nach Anspruch 6,
bei dem die Gesamtfiltergröße des Gehäuses kleiner oder gleich 2.5 x 2.0 mm$^2$ ist.

**8.** SAW-Filter nach einem der Ansprüche 1 bis 7,
bei welchem sich die statische Kapazität $C_{0p}1$ des Teilresonators von der statischen Kapazität $C_{0p}2$ des mit diesem auf dem Substrat direkt elektrisch an der Masseseite verbundenen Parallelresonators unterscheidet: $C_{0p}1 \neq C_{0p}2$.

**9.** Verfahren zum Verschieben einer Polstelle in einem SAW Filter nach einem der vorangehenden Ansprüche,
bei welchem die statische Kapazität $C_{0p}$ von mindestens einem der auf dem Substrat direkt elektrisch gekoppelten Resonatoren erhöht oder erniedrigt wird und zum Ausgleich die statische Kapazität des nicht derart verkoppelten Teilresonators und/oder die statische Kapazität eines oder mehrerer weiterer in weiteren Querzweigen angeordneter nicht verkoppelter Parallelresonatoren so erniedrigt oder erhöht wird, daß die Gesamtsumme $\Sigma C_{0p}$ der statischen Kapazitäten aller Parallelresonatoren identisch bleibt.

**10.** Verfahren nach Anspruch 9,
bei welchem im SAW Filter nach einem der Ansprüche 1 bis 8 der zumindest eine Serienresonator im seriellen Zweig zwischen den beiden parallen Zweigen angeordnet ist und mindestens ein weiterer Serienresonator nicht im seriellen Zweig zwischen den beiden parallen Zweigen angeordnet ist,
bei dem die statische Kapazität $C_{0s}$ des Serienresonators gegenüber einem Ausgangswert erhöht oder erniedrigt wird und zum Ausgleich die statische Kapazität des mindestens einen weiteren Serienresonators so erniedrigt oder erhöht wird, daß die Gesamtsumme $\Sigma C_{0s}$ der statischen Kapazitäten aller Serienresonatoren identisch bleibt.

**11.** Verfahren nach einem der Ansprüche 9 oder 10,
bei dem durch Variation des Teilungsverhältnisses der statischen Kapazitäten der beiden Teilresonatoren die statische Kapazität $C_{0p}$ der gekoppelten Resonatoren variiert und damit die Frequenzlage der verkoppelten Polstelle eingestellt wird.

**12.** Verfahren nach einem der Ansprüche 9 bis 11,
bei welchem das Produkt $\Pi C_{0p}$ der statischen Kapazitäten $C_{0p}1$ und $C_{0p}2$ der gekoppelten Resonatoren zur Einstellung der Frequenzlage der verkoppelten Polstelle variiert wird, wobei die statische Kapazität $C_{0p}1$ des Teilresonators um den gleichen Betrag $C_{const}$ erhöht wird wie die statische Kapazität $C_{0p}2$ des mit ihm gekoppelten Parallelresonators erniedrigt wird, so daß die Summe der statischen Kapazitäten $C_{0p}1$ und $C_{0p}2$ identisch bleibt.

**Claims**

**1.** SAW filter of the reactance filter type,

- having a series branch in which at least one series resonator ($R_{s2}$) is arranged,
- having a first and a second parallel branch, with the first and the second parallel branch being connected at different electrical nodes to the series branch, with the parallel branch being connected to reference earth potential,

- wherein a parallel resonator ($R_p$) is arranged in each parallel branch,
- wherein the series branch and the parallel branches are formed on a piezoelectric substrate,
- wherein the filter can be electrically connected to a housing,
- wherein the parallel resonator which is arranged in the first parallel branch is split into two resonator elements ($R_{p2}$, $R_{p3}$) such that

    - the two resonator elements form an electrical three-port network which has a common connecting strip (28-4) on the input side and has two separate busbars (28-5, 28-6) on the output side, with each busbar corresponding to the output of one of the two resonator elements,
      or
    - so that the two resonator elements form two electrical two-port networks with separate busbars on the input side and on the output side,

- wherein one of the resonator elements in the first parallel branch ($R_{p2}$) and the parallel resonator ($R_{p1}$) are coupled resonators which are coupled to one another by means of an electrical connection, which is formed on the substrate, on the earth sides, and wherein the earth sides are electrically connected before the link is made to the housing.

2. SAW filter according to Claim 1,
   in which the electrical connection comprises a stripline on the substrate.

3. SAW filter according to Claim 1 or 2,
   in which the electrical connection comprises a bonding connection between two pads on the substrate.

4. SAW filter according to one of Claims 1 or 3, in which the housing link between the electrically connected earth sides (12-6, 12-7) of the resonator element and the parallel resonator which is electrically connected to the earth side comprises a bump connection (30-5).

5. SAW filter according to one of Claims 1 to 4, in which the housing link between the electrically connected earth sides of the coupled resonators comprises a bonding connection.

6. SAW filter according to one of Claims 1 to 5, which is installed in a housing by means of flip-chip technology.

7. SAW filter according to Claim 6, in which the overall filter size of the housing is less than or equal to 2.5 x 2.0 mm$^2$.

8. SAW filter according to one of Claims 1 to 7, in which the static capacitance $C_{0p}1$ of the resonator element differs from the static capacitance $C_{0p}2$ of the parallel resonator which is electrically connected to it directly on the substrate on the earth side: $C_{0p}1 \neq C_{0p}2$.

9. Method for movement of a pole point in an SAW filter according to one of the preceding claims, in which the static capacitance $C_{0p}$ of at least one of the resonators which are electrically coupled directly on the substrate is increased or decreased, and the static capacitance of the resonator element which is not coupled and/or the static capacitance of one or more further parallel resonators which are arranged in further parallel branches and are not coupled is decreased or increased for compensation such that the total sum $\Sigma C_{0p}$ of the static capacitances of all the parallel resonators remains the same.

10. Method according to Claim 9, in which, in the SAW filter according to one of Claims 1 to 8, the at least one series resonator is arranged in the series branch between the two parallel branches, and at least one further series resonator is not arranged in the series branch between the two parallel branches,
    in which the static capacitance $C_{0s}$ of the series resonator is increased or decreased in comparison to an initial value, and the static capacitance of the at least one further series resonator is decreased or increased for compensation, such that the total sum $\Sigma C_{0s}$ of the static capacitances of all the series resonators remains identical.

11. Method according to one of Claims 9 or 10, in which the static capacitance $C_{0p}$ of the coupled resonators is varied by variation of the division ratio of the static capacitances of the two resonator elements, and the frequency of the coupled pole point is set in this way.

**12.** Method according to one of Claims 9 to 11, in which the product $\Pi C_{0p}$ of the static capacitances $C_{0p}1$ and $C_{0p}2$ of the coupled resonators is varied in order to set the frequency of the coupled pole point, wherein the static capacitance $C_{0p}1$ of the resonator element is increased by the same amount $C_{const}$ as the static capacitance $C_{0p}2$ of the parallel resonator which is coupled to it is decreased, so that the sum of the static capacitances $C_{0p}1$ and $C_{0p}2$ remains identical.

**Revendications**

**1.** Filtre à ondes de surface du type filtre à réactance,

- avec une branche sérielle, dans laquelle est placé au moins un résonateur série ($R_{s2}$),
- avec une première et une deuxième branche parallèle, la première et la deuxième branche parallèle étant raccordées à différents noeuds électriques sur la branche sérielle, les branches parallèles étant branchées au potentiel de référence,
- un résonateur parallèle ($R_p$) étant placé dans chaque branche parallèle,
- la branche sérielle et les branches parallèles étant conçues sur un substrat piézoélectrique,
- le filtre pouvant être relié électriquement à un boîtier,
- le résonateur parallèle placé dans la première branche parallèle étant divisé en deux résonateurs partiels ($R_{p2}$, $R_{p3}$), de telle sorte

  - que les deux résonateurs partiels forment un élément électrique à trois portes qui comporte côté entrée une plaque à bornes (28-4) commune et côté sortie deux barres omnibus (28-5, 28-6) séparées, chaque barre omnibus correspondant à la sortie de l'un des deux résonateurs partiels, ou
  - que les deux résonateurs partiels forment deux éléments électriques à deux portes avec côté entrée et côté sortie des barres omnibus séparées,

- l'un des résonateurs partiels de la première branche parallèle ($R_{p2}$) et le résonateur parallèle ($R_{p1}$) placé dans la deuxième branche parallèle étant des résonateurs couplés qui sont couplés entre eux par une liaison électrique, conçue sur le substrat, des côtés de masse, la liaison électrique des côtés de masse s'effectuant avant la connexion au boîtier.

**2.** Filtre à ondes de surface selon la revendication 1,
tel que la liaison électrique comprend une ligne à rubans sur le substrat.

**3.** Filtre à ondes de surface selon la revendication 1 ou 2,
tel que la liaison électrique comprend une liaison du type bonding entre deux broches sur le substrat.

**4.** Filtre à ondes de surface selon l'une des revendications 1 à 3,
tel que la connexion au boîtier des côtés de masse reliés électriquement (12-6, 12-7) du résonateur partiel et du résonateur parallèle relié avec celui-ci électriquement au côté de masse comprend une liaison du type bump (30-5).

**5.** Filtre à ondes de surface selon l'une des revendications 1 à 4,
tel que la connexion au boîtier des côtés de masse reliés électriquement des résonateurs couplés comprend une liaison du type bonding.

**6.** Filtre à ondes de surface selon l'une des revendications 1 à 5,
qui est intégré par une technique Flip-Chip dans un boîtier.

**7.** Filtre à ondes de surface selon la revendication 6,
tel que la dimension de filtre totale du boîtier est inférieure ou égale à 2,5 x 2,0 mm$^2$.

**8.** Filtre à ondes de surface selon l'une des revendications 1 à 7,
tel que la capacité statique $C_{Op}1$ du résonateur partiel est différente de la capacité statique $C_{Op}2$ du résonateur parallèle relié électriquement avec celui-ci sur le substrat directement au côté de masse : $C_{Op}1 \neq C_{Op}2$.

**9.** Procédé pour déplacer un pôle dans un filtre à ondes de surface selon l'une des revendications précédentes,

dans lequel on augmente ou diminue la capacité statique $C_{Op}$ au moins de l'un des résonateurs directement couplés électriquement sur le substrat et, pour compenser, on diminue ou augmente la capacité statique du résonateur partiel qui n'est pas couplé ainsi et/ou la capacité statique d'un ou plusieurs autres résonateurs parallèles placés dans d'autres branches transversales et non couplés de telle sorte que la somme totale $\Sigma C_{Op}$ des capacités statiques de tous les résonateurs parallèles reste identique.

**10.** Procédé selon la revendication 9,

dans lequel, dans le filtre à ondes de surface selon l'une des revendications 1 à 8, le au moins un résonateur série est placé dans la branche sérielle entre les deux branches parallèles et au moins un autre résonateur série n'est pas placé dans la branche sérielle entre les deux branches parallèles ; on augmente ou diminue la capacité statique $C_{Os}$ du résonateur série par rapport à une valeur initiale ; et, pour compenser, on diminue ou augmente la capacité statique du au moins un autre résonateur série de telle sorte que la somme totale $\Sigma C_{Os}$ des capacités statiques de tous les résonateurs série reste identique.

**11.** Procédé selon l'une des revendications 9 ou 10,

dans lequel, en modifiant le rapport de division des capacités statiques des deux résonateurs partiels, on modifie la capacité statique $C_{Op}$ des résonateurs couplés et on règle donc la position en fréquence du pôle couplé.

**12.** Procédé selon l'une des revendications 9 à 11,

dans lequel on modifie le produit $\Pi C_{Op}$ des capacités statiques $C_{Op}1$ et $C_{Op}2$ des résonateurs couplés pour régler la position en fréquence du pôle couplé, la capacité statique $C_{Op}1$ du résonateur partiel étant augmentée de la même valeur $C_{const}$ dont est aussi diminuée la capacité statique $C_{Op}2$ du résonateur parallèle couplé avec lui de telle sorte que la somme des capacités statiques $C_{Op}1$ et $C_{Op}2$ reste identique.

FIG 1

1-1

1-3    1-2    1-4    1-5

FIG 2

$C_1$

$L_1$

$R_1$

$C_0$

$\triangleq$

$R$

FIG 3

3-1    3-3

$R_1$

$R_2$

$L_{ser}$

3-2    3-4

# FIG 4

# FIG 5

## FIG 6

$Z_{in}$ $Z_{out}$ $Z_{in}$ $Z_{out}$

6-1 6-2

## FIG 7

$Z_S$ $Z_S$

$Y_p$ $Y_p$ $Y_p$

## FIG 8

$2Z_S$ $Z_S$

$Y_p$ $2Y_p$

18

## FIG 9

9-0

R4

R5

9-17

9-8

9-9

9-4

R1

R2

R3

9-1

9-15

9-10

9-11

9-12

9-5

9-7

## FIG 10

10-17

10-9

10-3

10-5

## FIG 11A

## FIG 11B

## FIG 12

R1

R2

R3

12-8

Chip

12-6

12-5

L$_{ser}$

12-7

12-4

## FIG 13

C$_{0s}$

Z'

C$_{0p1}$

C$_{0p2}$

Z

Z''

L$_{ser}$

## FIG 14

## FIG 15

## FIG 16

## FIG 17

FIG 18

# FIG 19

# FIG 20

FIG 21

## FIG 22

## FIG 23

## FIG 24

# FIG 25

# FIG 26

FIG 27

EP 1 196 991 B1

# FIG 28

# FIG 29

FIG 30

## FIG 31